# EUROPÄISCHE PATENTANMELDUNG

(11) **EP 0 578 020 A2**
(43) Veröffentlichungstag der Anmeldung: **12.01.1994**
(21) Anmeldenummer: 93109638.2
(22) Anmeldetag: 16.06.1993
(51) Int. Cl.: H04R 25/00, H03K 3/03, H03B 5/20

(54) **Hörgerät mit einem integrierten Schaltkreis**

(30) Priorität: 29.06.1992 DE 4221304
(71) Anmelder: Siemens Audiologische Technik GmbH, D-91058 Erlangen (DE)
(72) Erfinder: Martin, Raimund, Dipl.-Ing., D-8557 Eggolsheim (DE); Pfannenmüller, Gerhard, D-8507 Oberasbach (DE)
(74) Vertreter: Fuchs, Franz-Josef, Dr.-Ing.

(57) **Zusammenfassung**

Ein Hörgerät soll mit einem integrierten Schaltkreis (8), der wenigstens einen Oszillator (7) aufweist, dessen Frequenz kapazitiv wählbar ist, so ausgebildet werden, daß die Frequenz des integrierten Oszillators (7) digital wählbar ist. Dazu sind in dem integrierten Schaltkreis (8) mindestens zwei kapazitiv wirkende Komponenten als Teilkondensatoren (C1 bis C6) integriert, mit denen die Frequenz des Oszillators wählbar ist. Dabei ist wenigstens einer der Teilkondensatoren (C1 bis C6) über ein integriertes Schaltmittel (S1 bis S6) an dem Oszillator (7) zu- oder abschaltbar ausgebildet.

## Beschreibung

Die Erfindung bezieht sich auf ein Hörgerät mit einem integrierten Schaltkreis, der einen Oszillator aufweist, dessen Frequenz kapazitiv wählbar ist.

Bei bekannten Hörgeräten dieser Art wird die Frequenz des Oszillators durch einen extern an den integrierten Schaltkreis anschließbaren Kondensator oder Quarz gewählt. Dadurch entsteht vor allem ein relativ großer Platzbedarf in dem Hörgerät sowohl für die Anordnung eines Kondensators oder eines Quarzes als auch für die Befestigung und Verbindung mit dem integrierten Schaltkreis.

Man hat in integrierten Schaltkreisen auch schon kapazitiv wirkende Komponenten, z.B. Kapazitätsdioden, zum Abgleich der Frequenz eines Oszillators integriert. Für die Abstimmung der Kapazitätsdioden ist eine analog einstellbare Spannung erforderlich, die außerdem stabilisiert sein muß. Der dazu erforderliche Aufwand ist relativ hoch.

Aus der DE-33 45 921 A1 ist ein Hörgerät mit einem integrierten Schaltkreis bekannt. Ein Hochpaßfilter und ein Tiefpaßfilter bilden monolithisch integrierte Filter mit über elektronische Schalter geschalteten Kapazitäten. Die Grenzfrequenzen der Filter werden durch Ändern der Frequenz einer Wechselspannung (= Taktfrequenz) an Steuereingängen der Filter verändert. Die Taktfrequenz wird über einen Oszillator erzeugt, dessen Frequenz teilbar ist. Die zur Frequenzteilung vorgesehenen Frequenzteiler sind in ihrem Teilungsverhältnis einstellbar. Die Einstellung der Frequenzteilung wird mittels Daten vorgenommen, die in einem nicht flüchtigen Speicher gespeichert sind und die Grenzfrequenz der Filter steuern.

Aus der DE-38 34 962 A1 ist ein digitales Programmiergerät für Hörgeräte bekannt, das einen Mikrocontroller enthält. Aus der DE-32 05 686 C2 ist ein Hörgerät mit einem Mikrorechner bekannt. Mikrocontroller bzw. Mikrorechner benötigen für die Taktsignalerzeugung einen Oszillator.

Der Erfindung liegt die Aufgabe zugrunde, bei einem Hörgerät der eingangs genannten Art den Oszillator des integrierten Schaltkreises so auszubilden, daß dessen Frequenz digital wählbar ist.

Diese Aufgabe wird durch ein Hörgerät mit den Merkmalen gemäß Anspruch 1 gelöst. Bei dem erfindungsgemäßen Hörgerät sind in dem integrierten Schaltkreis mindestens zwei kapazitiv wirkende Komponenten als Teilkondensatoren integriert, mit denen die Frequenz des Oszillators abgleichbar ist. Dazu ist wenigstens ein integrierter Teilkondensator über ein integriertes Schaltmittel, z.B. in Abhängigkeit von einem digitalen Schaltsignal, an den Oszillator zu- oder abschaltbar ausgebildet. Durch die digitale Zu- oder Abschaltung wenigstens eines Teilkondensators über ein integriertes Schaltmittel sind wenigstens zwei Frequenzen des Oszillators wählbar. Dadurch entfällt der Aufwand für eine analog einstellbare und stabilisierte Abstimmspannung. Der Platzbedarf für in den IC integrierte Teilkondensatoren und Schaltmittel ist deutlich geringer als der Platzbedarf z.B. für einen Kondensator, der nachträglich außerhalb an dem integrierten Schaltkreis angeordnet ist.

In Ausbildung der Erfindung sind mehrere kapazitv wirkende Komponenten als Teilkondensatoren in dem integrierten Schaltkreis vorgesehen. Dabei sind die Teilkondensatoren über je ein integriertes Schaltmittel unabhängig voneinander an den Oszillator durch das Schaltsignal zu- oder abschaltbar. Als Schaltmittel eignen sich vorzugsweise integrierte MOS-Schalter.

Weitere Vorteile und Einzelheiten ergeben sich aus der nachfolgenden Beschreibung erfindungsgemäßer Ausführungsbeispiele anhand der Zeichnungen und in Verbindung mit den Ansprüchen.

Es zeigen:
Figur 1 ein Hörgerät mit einem integrierten Schaltkreis, der einen kapazitiv abstimmbaren Oszillator aufweist und
Figur 2 ein Hörgerät gemäß Figur 1 mit detaillierterer Darstellung der Oszillatorschaltung.

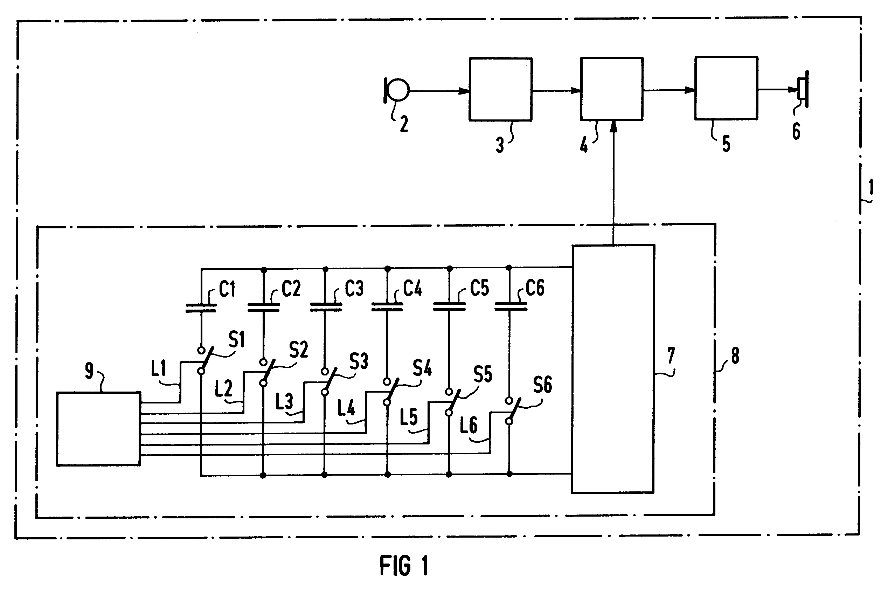

In Figur 1 ist durch eine strichpunktierte Linie ein Hörgerät 1 symbolisch dargestellt. Das Hörgerät 1 umfaßt als Eingangswandler ein Mikrofon 2 zur Aufnahme von Nutzsignalen im menschlichen Hörbereich. Die Nutzsignale werden in einem Verstärker 3 vorverstärkt und über eine Nutzsignalbearbeitungsanordnung 4 sowie über eine Endstufe 5 einem als Ausgangsspannungswandler ausgebildeten Hörer 6 zugeführt. Die Nutzsignalbearbeitungsanordnung 4 kann z.B. eine Schaltung zum Erzeugen eines pulsdauermodulierten Signals enthalten, wobei die Endstufe 5 als Schaltverstärker ausgebildet ist. Die Nutzsignalbearbeitungsanordnung 4 kann aber auch eine andere zeitdiskrete (z.B. digitale) Nutzsignalbearbeitungsanordnung sein, die z.B. eingangsseitig einen Analog-Digital-Wandler und ausgangsseitig einen Digital-Analog-Wandler umfaßt. In jedem Fall wird für die Nutzsignalbearbeitungsanordnung ein Basissignal, z.B. Taktsignal oder Dreiecksignal, aus einem Oszillator 7 benötigt.

Der Oszillator 7 ist ein Bestandteil eines integrierten Schaltkreises (= IC) 8. In den integrierten Schaltkreis 8 sind als kapazitiv wirkende Komponenten Teilkondensatoren C1 bis C6 monolithisch integriert. Jeder Teilkondensator C1 bis C6 bildet mit je einem ebenfalls monolithisch in dem IC 8 integrierten Schaltmittel S1 bis S6 eine Reihenschaltung. Alle Reihenschaltungen aus einem Teilkondensator und einem Schaltmittel sind zueinander parallelgeschaltet. Die in der Figur 1 symbolisch als Schalter dargestellten Schaltmittel S1 bis S6 können vorteilhaft als integrierte MOS-Schalter ausgebildet sein.

Die Teilkondensatoren C1 bis C6 können bezüglich ihrer jeweiligen Einzelkapazität unterschiedlich ausgebildet sein. Vorteilhaft ist es, wenn z.B. der erste Teilkondensator C1 die geringste Einzelkapazität hat. Jeder weitere Teilkondensator C2 bis C6 kann dann die jeweils doppelte Kapazität gegenüber dem jeweils vorhergehenden Teilkondensator C1 bis C5 aufweisen. Dadurch wird mit relativ wenigen Teilkondensatoren ein großer Variationsbereich der wählbaren Gesamtkapazität durch Parallelschalten von Teilkondensatoren mit derart unterschiedlich gestuften Kapazitätswerten erreicht.

Die Schaltmittel S1 bis S6 sind zur Steuerung vom leitenden in den nicht leitenden Zustand und umgekehrt jeweils über eine Leitung L1 bis L6 mit einem Datenspeicher 9 verbunden. In dem Datenspeicher 9, der vorzugsweise als nicht flüchtiger Datenspeicher und monolithisch als ein Bestandteil des integrierten Schaltkreises 8 ausgebildet ist, ist ein digitales Schaltsignal als binäres Datenwort speicherbar.

Das in dem Datenspeicher 9 als digitales Schaltsignal gespeicherte binäre Datenwort hat beispielsweise eine Bit-Zahl, die der Anzahl der Schaltmittel S1 bis S6 entspricht. Dadurch kann jedes Schaltmittel S1 bis S6 von je einem Bit des Datenwortes durch eine parallele Bit-Ausgabe aus dem Datenspeicher 9 über die Leitungen L1 bis L6 gesteuert werden. Durch die parallele Ausgabe der einzelnen Bits des gespeicherten Datenwortes ist jeder Schalter S1 bis S6 auf einfachste Weise leitend oder nicht leitend schaltbar.

Die Gesamtkapazität des Oszillators 7 wird folglich durch die jeweils zugeschalteten und damit zueinander parallelgeschalteten Teilkondensatoren C1 bis C6 bestimmt. Dadurch wird eine recht genaue Wählbarkeit der gewünschten Oszillatorfrequenz erreicht, wobei der Oszillator 7 auch eine nicht schaltbare Grundkapazität aufweisen kann. Durch die erfindungsgemäße Aufteilung der Gesamtkapazität in schaltbare Teilkondensatoren können auch unvermeidliche Streuungen beim Herstellungsprozeß des integrierten Schaltkreises bezüglich der wählbaren Oszillatorfrequenz ausgeglichen werden.

Das Datenwort, mit dem die gewünschte Oszillatorfrequenz wählbar ist, kann bereits wahrend des Herstellungsprozesses der integrierten Schaltung 8 in den Datenspeicher 9 eingegeben werden oder erst bei der Herstellung des Hörgerätes. Ein weiterer Vorteil ist, daß das Datenwort auch später noch umprogrammierbar ist und damit eine spätere Frequenzänderung ohne Änderung von Schaltungsteilen möglich wird.

Es ist vorteilhaft, wenn der IC 8 des Hörgerätes so ausgebildet ist, daß mit dem binär niedrigsten Bit des Datenwortes der bezüglich seiner Kapazität kleinste Kondensator C1 über das Schaltmittel S1 schaltbar ist. Mit dem binär jeweils nächstgrößeren Bit des Datenwortes ist sodann der bezüglich seiner Kapazität nächstgrößere Kondensator C1 bis C6 über das jeweilige Schaltmittel S2 bis S6 schaltbar.

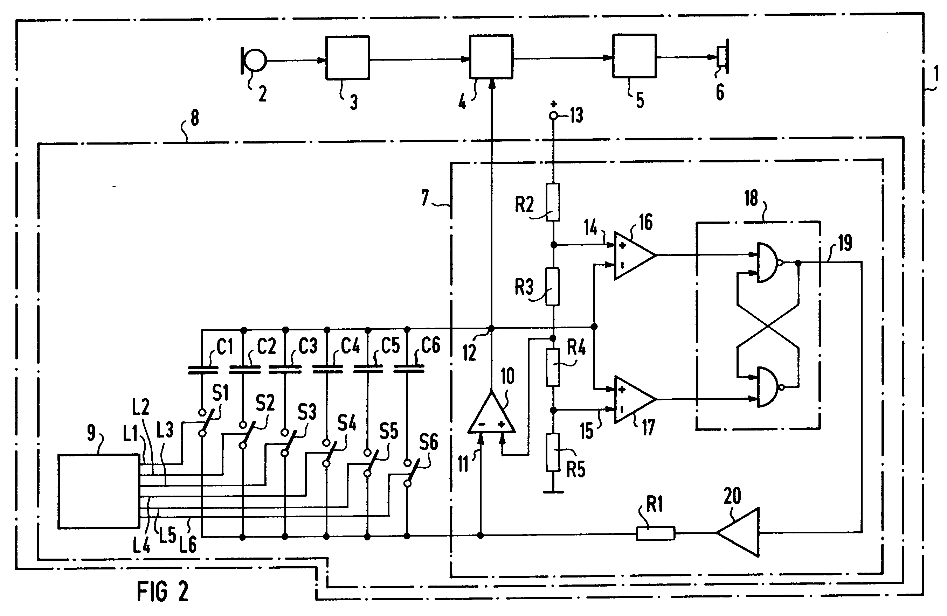

In Figur 2 sind gleichartige Hörgerätekomponenten durch dieselben Bezugsziffern bezeichnet wie in Figur 1. Der Oszillator 7 ist in dem Ausführungsbeispiel gemäß Figur 2 ein spezieller Oszillator, der als ein die Frequenz mitbestimmendes Glied einen Integrator aufweist. Dieser Integrator umfaßt einen Operationsverstärker 10, dessen Zeitkonstante durch die Teilkondensatoren C1 bis C6 und einen Widerstand R1 abhängig ist. Die schaltbaren Teilkondensatoren C1 bis C6 wirken als kapazitive Gegenkopplung zwischen einem Eingang 11 und einem Ausgang 12 des Operationsverstärkers 10. An dem Ausgang 12 des Operationsverstärkers 10 steht ein Dreieckspannungssignal zur Verfügung, das als ein Basissignal zur Erzeugung eines pulsdauermodulierten Signals in der Nutzsignalbearbeitungsanordnung 4 dienen kann.

Der Oszillator 7 weist eine Reihenschaltung aus vier Widerständen R2 bis R5 auf. Die Reihenschaltung dieser Widerstände R2 bis R5 bildet einen Spannungsteiler, der über einen Anschluß 13 mit einer Betriebsspannungsquelle, z.B. mit dem Pluspol einer Hörgerätebatterie, verbindbar ist. Der Spannungsteiler liefert über eine Leitung 14 eine hohe und über eine Leitung 15 eine niedrige Schwellenspannung an eine aus zwei Komparatoren 16 und 17 gebildete Vergleichsschaltung. Dieser Vergleichsschaltung wird auch das Dreiecksignal zugeführt, das am Ausgang 12 des Integrators 10 zur Verfügung steht. Das Dreiecksignal kann in der Amplitude (Scheitelwert) zwischen den Schwellenspannungen der beiden Leitungen 14 und 15 schwanken. Wenn die Amplitude des Dreiecksignals eine der Schwellenspannungen erreicht, gibt einer der Komparatoren 16 oder 17 ein Ausgangssignal an eine bistabile Kippstufe 18 ab. Dadurch ändert sich an einem Ausgang 19 der bistabilen Kippstufe 18 der Pegel von z.B. einem hohen Wert auf einen niedrigen Wert oder umgekehrt. Mit dem Ausgang 19 ist über einen Treiber 20 und den Widerstand R1 der Eingang 11 des Operationsverstärkers 10 verbunden.

Durch die Umschaltung des Ausgangspegels an der Kippstufe 18 ändert sich folglich auch der Pegel am Eingang 11 des Operationsverstärkers 10. Diese Pegeländerung bewirkt eine Umkehr der Integrationsrichtung des Integrators. Sobald durch die umgekehrte Integration wiederum eine Übereinstimmung mit einer der Schwellenspannungen der Leitungen 14 oder 15 erreicht wird, erfolgt eine erneute Umschaltung der bistabilen Kippstufe 18 durch ein Signal aus einem der Komparatoren 16 oder 17. Dadurch wird die Integrationsrichtung des Integrators erneut umgekehrt. Die Anordnung schwingt folglich und bildet einen Oszillator.

Die Oszillatorfrequenz ist - wie bereits erwähnt - von der Zeitkonstante des Integrators 10 abhängig, die sich aus dem Widerstand R1 und den jeweils eingeschalteten Teilkondensatoren C1 bis C6 ergibt und wird auch noch durch die Wahl der Schwellenspannungen auf den Leitungen 14 und 15 beeinflußt. Eine Frequenzauswahl ist sonach erfindungsgemäß durch die monolithisch integrierten Teilkondensatoren C1 bis C6 möglich, ohne daß externe Komponenten oder analog einstellbare Spannungen an den integrierten Schaltkreis 8 des Hörgerätes 1 angelegt werden müssen.

## Patentansprüche

1. Hörgerät mit einem integrierten Schaltkreis (8), der wenigstens einen Oszillator (7) aufweist, dessen Frequenz kapazitiv wählbar ist, wobei in dem integrierten Schaltkreis (8) mindestens zwei kapazitiv wirkende Komponenten als Teilkondensatoren (C1 bis C6) integriert sind, mit denen die Frequenz des Oszillators wählbar ist und wobei wenigstens einer der Teilkondensatoren (C1 bis C6) über ein integriertes Schaltmittel (S1 bis S6) an dem Oszillator (7) zu- oder abschaltbar ausgebildet ist.

2. Hörgerät nach Anspruch 1, wobei alle Teilkondensatoren (C1 bis C6) in dem integrierten Schaltkreis (8) über je ein integriertes Schaltmittel (S1 bis S6) voneinander unabhängig an den Oszillator (7) zu- oder abschaltbar sind.

3. Hörgerät nach Anspruch 1 oder 2, wobei jedes Schaltmittel (S1 bis S6) als integrierter MOS-Schalter ausgebildet ist.

4. Hörgerät nach einem der Ansprüche 1 bis 3, wobei jeweils ein Teilkondensator (C1 bis C6) mit jeweils einem Schaltmittel (S1 bis S6) eine Reihenschaltung bildet und wobei alle Reihenschaltungen zueinander parallelgeschaltet sind.

5. Hörgerät nach einem der Ansprüche 1 bis 4, wobei der integrierte Schaltkreis (8) einen vorzugsweise nicht flüchtigen Datenspeicher aufweist, in welchem ein digitales Schaltsignal für die Schaltmittel (S1 bis S6) als ein binäres Datenwort speicherbar ist.

6. Hörgerät nach einem der Ansprüche 1 bis 5, wobei die Teilkondensatoren (C1 bis C6) bezüglich ihrer Kapazität unterschiedlich ausgebildet sind, derart, daß ein erster Teilkondensator (C1) die geringste Einzelkapazität hat und jeder weitere Teilkondensator (C2 bis C6) die jeweils doppelte Kapazität gegenüber dem jeweils vorhergehenden Teilkondensator (C1 bis C6) aufweist.

7. Hörgerät nach Anspruch 5 oder 6, wobei das in dem Datenspeicher (9) als digitales Schaltsignal gespeicherte binäre Datenwort eine Bit-Zahl aufweist, die der Anzahl der Schaltmittel (S1 bis S6) entspricht und wobei jedes Schaltmittel (S1 bis S6) durch je ein Bit des im Datenspeicher (9) gespeicherten Datenwortes steuerbar ist.

8. Hörgerät nach Anspruch 7, wobei über das Schaltmittel (S1) der Kondensator (C1) mit der kleinsten Kapazität mit dem binär niedrigsten Bit und die Kondensatoren (C2 bis C6) mit zunehmend größeren Kapazitäten mit dem binär jeweils nächstgrößeren Bit des Datenwortes schaltbar sind.
